# EUROPÄISCHE PATENTSCHRIFT

(11) **EP 1 016 335 B1**
(45) Veröffentlichungstag und Bekanntmachung des Hinweises auf die Patenterteilung: **19.12.2001**
(21) Anmeldenummer: 98951259.5
(22) Anmeldetag: 02.09.1998
(51) Int. Cl.: H05K 7/14

(54) **ELEKTRISCHES GERÄT MIT EINEM JUSTIERELEMENT**
ELECTRICAL DEVICE WITH AN ADJUSTING ELEMENT
APPAREIL ELECTRIQUE A ELEMENT D'AJUSTAGE

(30) Priorität: 15.09.1997 DE 19740566
(43) Veröffentlichungstag der Anmeldung: 05.07.2000
(73) Patentinhaber: SIEMENS AKTIENGESELLSCHAFT, 80333 München (DE)
(72) Erfinder: BRÄUNLICH, Michael, D-09117 Chemnitz (DE); FÜGMANN, Frank, D-09114 Chemnitz (DE)
(86) Internationale Anmeldenummer: DE9802582
(87) Internationale Veröffentlichungsnummer: WO9914995

(56) Entgegenhaltungen:
- DE-U- 1 867 945
- FR-A- 2 567 304

## Beschreibung

Die vorliegende Erfindung betrifft ein elektrisches Gerät mit einem Gehäuse oder Gehäuseteil und einer ersten und einer zweiten Leiterplatte, die elektrisch leitend miteinander kontaktierbar sind, bzw. ein Gehäuse oder Gehäuseteil für ein elektrisches Gerät, das zur Aufnahme einer ersten und einer mit dieser kontaktierbaren zweiten Leiterplatte vorgesehen ist.

Zur Verbindung von Komponenten elektrischer und/oder elektronischer Baugruppen, z.B. den genannten beiden Leiterplatten, die vom Anwender zu handhaben sind, werden Steckverbinder mit zunehmend kleineren Rastermaßen eingesetzt. Dies ist sowohl durch die stetige Miniaturisierung solcher Baugruppen, als auch die moderne Fertigungstechnologie (Einsatz von SMT-Bauelementen) bedingt.

Dadurch wird eine feinere und genauere mechanische Führung der Komponenten (der genannten Leiterplatten) zueinander erforderlich, um die Steckverbinder beim Bewegen der Baugruppenkomponenten nicht zu beschädigen oder den Steckvorgang für den Bediener weniger kompliziert und Feingefühl erfordernd zu gestalten.

Werden die Baugruppenkomponenten - die Leiterplatten oder die Komponenten des elektrischen Gerätes mit den darin enthaltenen Leiterplatten - nicht nur linear und damit in der Betätigungsrichtung des Steckverbinders gesteckt, sondern geschwenkt, verstärkt sich diese Problematik.

Im Stand der Technik ist es bekannt, die Leiterplatten in den Komponenten, auf denen die zu verbindenden Steckverbinder bestückt sind, im Gehäuse an definierten Punkten mit engen Toleranzen zu montieren, um damit deren Führung zu gewährleisten. Die Gehäuse der Komponenten wiederum erhalten eine ebenfalls mit engen Toleranzen versehene Führung zueinander. So wird erreicht, daß beim Zusammenstecken der Baugruppenkomponenten die Steckverbinder in eine Lage zueinander gebracht werden, die ein sicheres Stecken, und damit eine von außen nicht beeinflußbare Führung der Kontakte zueinander bewirkt.

Das gleichzeitige Wirken verschiedener Maße führt dabei dazu, daß die sich ergebenden Gesamttoleranzen im Vergleich zu dem Spiel des verwendeten Steckverbinders sehr groß werden. Dadurch sind einerseits aufwendige Maßnahmen zur Eingrenzung der einzelnen Toleranzen vor allem bei den Gehäuseteilen erforderlich, andererseits müssen die für diesen Anwendungsfall einsetzbaren Steckverbinder eine gewisse "Grobheit" aufweisen.

Aus DE-U-1 867 945 ist bekannt, die Leiterplatten jeweils in Führungsleisten einzuschieben und Führungsteile vorzusehen, die die Leiterplatten jeweils an deren kanten halten.

Die Aufgabe der vorliegenden Erfindung besteht demgemäß darin, ein elektrisches Gerät oder ein Gehäuse oder Gehäuseteil der oben genannten Art anzugeben, bei dem die mechanische Führung der Komponenten zueinander von der Gehäuseebene auf die Leiterplattenebene verlagert ist.

Diese Aufgabe wird für ein elektrisches Gerät der oben genannten Art dadurch gelöst, daß das Gehäuse oder Gehäuseteil zumindest ein Justierelement aufweist, das zur Führung und Fixierung sowohl der ersten als auch der zweiten Leiterplatte geeignet ist, daß die erste Leiterplatte eine auf den Querschnitt des Justierelements abgestimmte Ausnehmung aufweist, durch die das Justierelement im fixierten Zustand der ersten Leiterplatte hindurchragt, und daß das freie Ende des Justierelementes eine Kontur aufweist, die beim Kontaktieren der zweiten Leiterplatte zu deren Führung wirksam ist.

Analog wird die genannte Aufgabe durch ein Gehäuse oder Gehäuseteil der oben genannten Art dadurch gelöst, daß das Gehäuse oder Gehäuseteil zumindest ein Justierelement aufweist, das zur Führung und Fixierung sowohl der ersten als auch der zweiten Leiterplatte geeignet ist, wobei das Justierelement zum Führen und Fixieren der ersten Leiterplatte in eine auf den Querschnitt des Justierelementes abgestimmte Ausnehmung der ersten Leiterplatte eingreift und daß das freie Ende des Justierelementes eine Kontur aufweist, die beim Kontaktieren der zweiten Leiterplatte zu deren Führung wirksam ist.

Die oben beschriebene Kontur des freien Endes des Justierelementes kann z.B. eine schlitzförmige Kontur sein, wobei der Schlitz parallel zu einer durch den Steckverbinder der ersten Leiterplatte definierten Ebene ausgerichtet ist, so daß die zweite Leiterplatte durch diese Kontur des Justierelementes zumindest in Bezug auf eine Bewegungsrichtung justierbar ist.

Wenn die zweite Leiterplatte eine Führungskontur aufweist, die beim Kontaktieren der zweiten Leiterplatte mit der ersten Leiterplatte mit der Kontur des Justierelementes zum Eingriff kommt, ist eine exakte Führung der zweiten Leiterplatte beim Kontaktieren mit der ersten Leiterplatte in zwei Bewegungsrichtungen bewirkt. Damit ist die zweite Leiterplatte durch das Justierelement beim Kontaktieren mit der ersten Leiterplatte in den beiden zur Betätigungsrichtung des Steckverbinders senkrechten Bewegungsrichtungen geführt.

Wenn das Justierelement am Gehäuse oder Gehäuseteil einstükkig angeformt ist, ist aufgrund der Tatsache, daß das Justierelement mit dem Gehäuse unlösbar verbunden ist, eine besonders exakte Führung der Komponenten möglich.

Wenn das Justierelement zum freien Ende verjüngt ist, ist das Justieren der ersten Leiterplatte mittels der auf den Querschnitt des Justierelementes abgestimmten Ausnehmung dieser Leiterplatte vereinfacht.

Ein Ausführungsbeispiel der Erfindung wird nachstehend anhand der Zeichnung näher erläutert. Dabei zeigt:

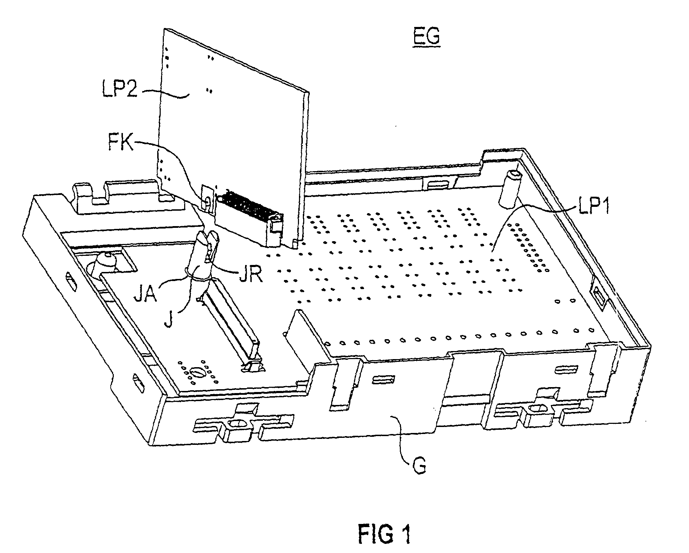

FIG 1 ein elektrisches Gerät bzw. ein Gehäuse oder Gehäuseteil mit einem Justierelement.

Gemäß FIG 1 weist das elektrische Gerät EG ein Gehäuse oder Gehäuseteil G auf. In dem Gehäuse oder Gehäuseteil G ist eine erste Leiterplatte LP1 angeordnet. Diese Leiterplatte LP1 ist mittels des Justierelementes J des Gehäuses G fixiert, indem das Justierelement J durch eine auf den Querschnitt des Justierelementes J abgestimmte Ausnehmung JA hindurchgreift.

Wenn, wie im Falle des Ausführungsbeispiels gemäß FIG 1, das Justierelement J zum freien Ende verjüngt ist, greift das Justierelement J in die Ausnehmung JA im fixierten Zustand der Leiterplatte LP1 formschlüssig ein, so daß die Leiterplatte LP1 in den beiden zur Achse des Justierelementes senkrechten Bewegungsrichtungen fixiert ist.

Die erste Leiterplatte LP1 weist ein Kontaktelement zum elektrisch leitenden Kontaktieren der ersten Leiterplatte LP1 mit einer zweiten Leiterplatte LP2 auf, die zu diesem Zweck ebenfalls ein Kontaktelement aufweist. Im Ausführungsbeispiel sind die beiden Kontaktelemente als Steckverbinder und korrespondierender Gegensteckverbinder ausgebildet.

Zur Führung der zweiten Leiterplatte LP2 weist das Justierelement J eine Kontur JR auf, die beim Kontaktieren der zweiten Leiterplatte LP2 mit der ersten Leiterplatte LP1 zur Führung der zweiten Leiterplatte LP2 wirksam ist. Im einfachsten Fall handelt es sich bei dieser Kontur JR um eine schlitzförmige Kontur JR, wobei der Schlitz JR parallel zu der durch den auf der ersten Leiterplatte LP1 angeordneten Steckverbinder definierten Ebene ausgerichtet ist.

Im Ausführungsbeispiel ist in der schlitzförmigen Kontur JR ein Steg vorgesehen, der beim Kontaktieren auch eine Führung der zweiten Leiterplatte LP2 in der zur durch den Steckverbinder der ersten Leiterplatte LP1 definierten Ebene parallelen Bewegungsrichtung ermöglicht. Zu diesem Zweck weist die zweite Leiterplatte LP2 eine Führungskontur FK auf, die mit der Kontur JK des Justierelementes J zum Eingriff kommt, wobei die schlitzförmige Kontur JR des Justierelementes J auf die Stärke der Leiterplatte LP2 selbst abgestimmt ist und wobei die Führungskontur FK im wesentlichen auf den Steg der Kontur JR des Justierelementes J abgestimmt ist.

Die Führungskontur FK der zweiten Leiterplatte LP2 ist dabei unmittelbar am Rand der Leiterplatte LP2 schlitzförmig ausgebildet, die sich in einer gewissen Entfernung vom Rand der Leiterplatte LP2 aufweitet und dort z.B. eine kreisförmige oder ovale Kontur besitzt, sich zumindest jedoch weiter öffnet als der Schlitz unmittelbar am Leiterplattenrand.

Beim Kontaktieren der zweiten Leiterplatte LP2 mit der ersten Leiterplatte LP1 wird die zweite Leiterplatte LP2 zunächst durch die schlitzförmige Kontur JR des Justierelementes J in der zur Ebene des Steckverbinders auf der ersten Leiterplatte LP1 parallelen Bewegungsrichtung geführt.

Wird beim Kontaktieren der zweiten Leiterplatte LP2 mit der ersten Leiterplatte LP1 die zweite Leiterplatte LP2 weit:er in Betätigungsrichtung des Steckverbinders bewegt, kommt der Steg innerhalb der schlitzförmigen Kontur JR des Justierelementes J mit der entsprechenden Ausnehmung FK der zweiten Leiterplatte LP2 zum Eingriff, so daß die zweite Leiterplatte LP2 beim Kontaktieren nunmehr zusätzlich auch in der zur durch die Ebene des Steckverbinders auf der ersten Leiterplatte LP1 definierten Ebene parallelen Bewegungsrichtung fixiert ist.

Beim weiteren Bewegen der Leiterplatte LP2 in Betätigungsrichtung des Steckverbinders kommen schließlich die Steckverbinder selbst miteinander zum Eingriff. Da eine genauere Führung der zweiten Leiterplatte LP2 als durch die Steckverbinder selbst nicht bewirkt werden kann, ist die Führungskontur FK der zweiten Leiterplatte LP2, wie bereits beschrieber, oberhalb der zunächst schlitzförmigen Kontur FK aufgeweitet, so daß der zunächst bestehende Formschluß mit dem Steg JR des Justierelements J gelöst wird.

Die zunächst starre Führung der Leiterplatte LP2 durch das Justierelement J bzw. durch das Zusammenwirken der Kontur des Justierelementes JR und der Führungskontur FK der zweiten Leiterplatte LP2 wird demnach gelöst, sobald die Steckverbinder selbst zum Eingriff kommen und damit eine definierte und sichere Führung gewährleistet ist.

Das Justierelement J bzw. dessen Kontur JR und die korrespondierende Führungskontur FK der zweiten Leiterplatte LP2 ist so ausgebildet, daß die zweite Leiterplatte LP2 mit der ersten Leiterplatte LP1 entweder in einer linearen Bewegung kontaktierbar ist, also gesteckt wird, oder in einer zumindest teilweise rotatorischen Bewegung kontaktierbar ist, also geschwenkt wird.

Wenn mit der ersten Leiterplatte LP1 mehrere Leiterplatten LP2 kontaktiert werden, kann für jede dieser zweiten Leiterplatten LP2 ein Justierelement J mit einer entsprechenden Kontur JR vorgesehen sein, das mit einer korrespondierenden Führungskontur FK der jeweiligen zweiten Leiterplatte LP2 zum Eingriff kommt.

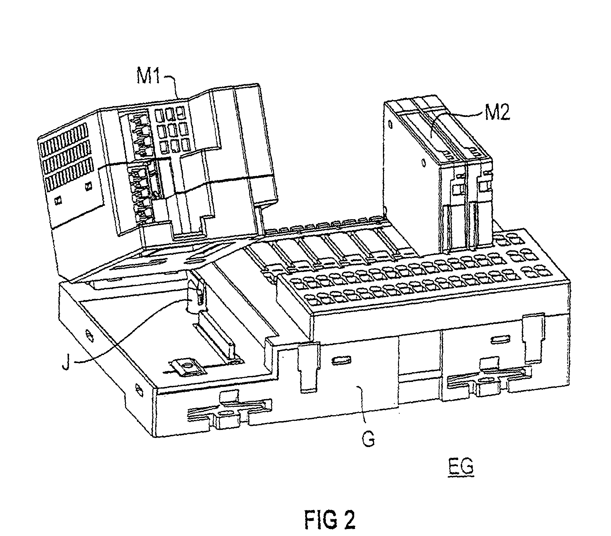

Wenn, wie in FIG 2 gezeigt, das Gehäuse oder Gehäuseteil G geschlossen ist, ragen nur noch die Steckverbinder und das Justierelement J durch entsprechende Ausnehmungen der Gehäuseelemente, so daß sie zur Kontaktierung bzw. zur Führung von in Modulen M1, M2 vorgesehenen Leiterplatten wirksam sind.

## Patentansprüche

1. Elektrisches Gerät (EG) mit einem Gehäuse oder Gehäuseteil (G) und einer ersten und einer zweiten Leiterplatte (LP1, LP2) die elektrisch leitend miteinander kontaktierbar sind,
- wobei das Gehäuse oder Gehäuseteil (G) zumindest ein Justierelement (J) aufweist, das zur Führung und Fixierung sowohl der ersten als auch der zweiten Leiterplatte (LP1, LP2) geeignet ist,
- wobei die erste Leiterplatte (LP1) eine auf den Querschnitt des Justierelementes (J) abgestimmte Ausnehmung (JA) aufweist, durch die das Justierelement (J) im fixierten Zustand der ersten Leiterplatte (LP1) hindurchragt und
- wobei das freie Ende des Justierelement (J) eine Kontur (JR) aufweist, die beim Kontaktieren der zweiten Leiterplatte (LP2) zu deren Führung wirksam ist.

2. Elektrisches Gerät nach Anspruch 1, **dadurch gekennzeichnet, daß** die zweite Leiterplatte (LP2) eine Führungskontur (FK) aufweist, die zum Kontaktieren der zweiten Leiterplatte (LP2) mit der ersten Leiterplatte (LP1) mit der Kontur (JK) des Justierelementes (J) zum Eingriff kommt.

3. Elektrisches Gerät nach Anspruch 1 oder 2, **dadurch gekennzeichnet, daß** das Justierelement (J) am Gehäuse oder Gehäuseteil (G) einstückig angeformt ist.

4. Elektrisches Gerät nach Anspruch 1, 2 oder 3, **dadurch gekennzeichnet, daß** das Justierelement (J) zum freien Ende verjüngt ist.

5. Gehäuse oder Gehäuseteil (G) für ein elektrisches Gerät (EG), das zur Aufnahme einer ersten Leiterplatte (LP1) und einer mit dieser kontaktierbaren zweiten Leiterplatte (LP2) vorgesehen ist und zumindest ein Justierelement (J) aufweist, das zur Führung und Fixierung sowohl der ersten als auch der zweiten Leiterplatte (LP1, LP2) geeignet ist, wobei das Justierelement zum Führen und Fixieren der ersten Leiterplatte in eine auf den Querschnitt des Justierelementes (J) abgestimmte Ausnehmung (JA) der ersten Leiterplatte (LP1) eingreift und wobei das freie Ende des Justierelementes (J) eine Kontur (JR) aufweist, die beim Kontaktieren der zweiten Leiterplatte (LP2) zu deren Führung wirksam ist.

6. Gehäuse oder Gehäuseteil nach Anspruch 5, **dadurch gekennzeichnet, daß** das Justierelement (J) am Gehäuse oder Gehäuseteil (G) einstückig angeformt ist.

7. Gehäuse oder Gehäuseteil nach Anspruch 5 oder 6, **dadurch gekennzeichnet, daß** das Justierelement (J) zum freien Ende verjüngt ist.

## Claims

1. Electrical device (EG) having a housing or housing part (G) and a first and a seocnd printed circuit board (LP1, LP2) that can be mutually connected in an electrically conducting manner
- wherein the housing or housing part (G) has at least one aligning element (J) that is suitable for guiding and locating both the first and the second printed circuit board (LP1, LP2),
- wherein the first printed circuit board (LP1) has a cutout (JA) that is matched to the cross section of the aligning element (J) and through which the aligning element (J) projects in the located state of the first printed circuit board (LP1),
- wherein the unsupported end of the aligning element (J) has a contour (JR) that, during the connection of the second printed circuit board (LP2), is active in its guidance and
- wherein the second printed circuit board (LP2) has a guide contour (FK) that, for the purpose of connecting the second printed circuit board (LP2) to the first printed circuit board (LP1), comes into engagement with the contour (JK) of the aligning element (J).

2. Electrical device according to Claim 1,
**characterized in that** the aligning element (J) is formed onto the housing of housing part (G) integrally.

3. Electrical device according to Claim 1 or 2,
**characterized in that** the aligning element (J) is tapered towards the unsupported end.

4. Housing or housing part (G) for an electrical device (EG) that is provided to receive a first printed circuit board (LP1) and a second printed circuit board (LP2) that can be connected to the latter, and has at least one aligning element (J) that is suitable for guiding and locating both the first and the second printed circuit board (LP1, LP2), wherein the aligning element for guiding and locating the first printed circuit board engages in a cutout (JA) of the first printed circuit board (LP1), which cutout is matched to the cross-section of the aligning element (J) and wherein the unsupported end of the aligning element (J) has a contour (JR) that, during connection of the second printed circuit board (LP2), is active in its guidance.

5. Housing or housing part according to Claim 4,
**characterized in that** the aligning element (J) is formed onto the housing or housing part (G) integrally.

6. Housing or housing part according to Claim 5,
**characterized in that** the aligning element (J) is tapered towards the unsupported end.

## Revendications

1. Appareil (EG) électrique comportant un boîtier ou une pièce (G) de boîtier et une première et une deuxième plaquette (LP1, LP2) à circuit imprimé qui peuvent être mises en contact l'une avec l'autre de manière conductrice de l'électrité,
- le boîtier ou la pièce (G) de boîtier comportant au moins un élément (J) d'ajustage qui convient au guidage et à l'immobilisation à la fois de la première plaquette (LP1) à circuit imprimé et de la deuxième plaquette (LP2) à circuit imprimé,
- la première plaquette (LP1) à circuit imprimé comportant un évidement (JA) qui est adapté à la section transversale de l'élément (J) d'ajustage et dans lequel l'élément (J) d'ajustage pénètre en l'état immobilisé de la première plaquette (LP1) à circuit imprimé,
- l'extrémité libre de l'élément (J) d'ajustage comportant un contour (JR) qui, lors de la mise en contact de la deuxième plaquette (LP2) à circuit imprimé, est efficace pour son guidage et
- la deuxième plaquette (LP2) à circuit imprimé comportant un contour (FK) de guidage qui, en vue de la mise en contact de la deuxième plaquette (LP2) à circuit imprimé avec la première plaquette (LP1) à circuit imprimé, vient en prise avec le contour (JK) de l'élément (J) d'ajustage.

2. Appareil électrique suivant la revendication 1, **caractérisé en ce que** l'élément (J) d'ajustage est réalisé d'un seul tenant avec le boîtier ou la pièce (G) de boîtier.

3. Appareil électrique suivant la revendication 1 ou 2, **caractérisé en ce que** l'élément (J) d'ajustage se rétrécit vers l'extrémité libre.

4. Boîtier ou pièce (G) de boîtier pour un appareil (EG) électrique qui est prévu pour la réception d'une premiére plaquette (LP1) à circuit imprimé et d'une deuxième plaquette (LP2) à circuit imprimé pouvant être mise en contact avec la première et qui comporte au moins un élément (J) d'ajustage qui convient au guidage et à l'immobilisation à la fois de la première plaquette (LP1) à circuit imprimé et de la deuxième plaquette (LP2) à circuit imprimé, l'élément d'ajustage rentrant, pour le guidage et l'immobilisation de la première plaquette (LP1) à circuit imprimé, dans un évidement (JA) de la première plaquette (LP1) à circuit imprimé adapté à la section transversale de l'élément (J) d'ajustage et l'extrémité libre de l'élément (J) d'ajustage comportant un contour (JR) qui, lors de la mise en contact de la deuxième plaquette (LP2) à circuit imprimé, est efficace pour son guidage.

5. Boîtier ou pièce de boîtier suivant la revendication 4, **caractérisé en ce que** l'élément (J) d'ajustage est réalisé d'un seul tenant sur le boîtier ou la pièce (G) de boîtier.

6. Boîtier ou pièce de boîtier suivant la revendication 5, **caractérisé en ce que** l'élément (J) d'ajustage se rétrécit vers l'extrémité libre.
